# EUROPEAN PATENT APPLICATION

(11) **EP 2 933 835 A1**
(43) Date of publication of application: **21.10.2015**
(21) Application number: 14164753.7
(22) Date of filing: 15.04.2014
(51) Int. Cl.: H01L 23/66, H01L 23/00, H03F 1/56, H01L 23/64

(54) **RF power transistor**

(71) Applicant: NXP B.V., 5656 AG Eindhoven (NL)
(72) Inventor: Zhu, Yi, Redhill, Surrey RH1 1SH (GB)
(74) Representative: Miles, John Richard

(57) **Abstract**

A semiconductor device including an RF power transistor in a semiconductor package is described. The semiconductor device comprises a gate lead frame, a drain lead frame, a die including a power transistor having a gate and a drain and a flange. A gate impedance matching network is connected between the gate lead frame and the gate. A drain impedance matching network is connected between the drain lead frame and the drain and includes a drain lead frame bond wire between the drain lead frame and the drain. A first conducting element is connected between the die and the flange and is arranged to provide a current path along which a return current can flow in use to lower an inductance associated with the drain lead frame bond wire.

## Description

The present invention relates to RF power transistors and in particular to impedance matching for RF power transistors.

RF power transistors are used to handle higher frequency electrical signals in higher power electronics applications. For example, RF power transistors can be used in RF power amplifiers. Such amplifiers have a wide range of applications including use in base stations for wireless or cellular telephone networks.

Other uses of RF power transistors include broadcast infrastructure, radar and automotive igniters

Impedance matching can be used to improve the performance of electrical circuits by matching the impedance presented by one electrical component to other parts of the circuit, for example matching the impedance presented by a load to a signal source. Impedance matching can be used in power electronics applications in order to improve the passage of electrical energy through the system.

An RF power transistor can include a die having a plurality of transistors and which is mounted on a conducting flange. The gates and drains of the transistors are connected to a lead frame of the device using bond wires. An encapsulant houses these parts, leaving the lead frame connectors and flange as terminals for connecting to the remainder of the electrical circuit. This arrangement is often referred to as a package. Impedance matching networks can be provided in-package as part of the RF power transistor.

The electrical behaviour of the components used for impedance matching tends to vary with the frequency of the electrical signals being handled. Hence, an impedance matching network that provides adequate impedance matching at a first frequency may not perform as well at a different frequency.

Hence, impedance matching that operates over a range of RF frequencies would be useful in RF power transistors.

The present invention relates to in-package impedance matching for RF power transistors.

A first aspect of the invention provides a semiconductor device comprising an RF power transistor in a semiconductor package, comprising: a gate lead frame; a drain lead frame; a die including a power transistor having a gate and a drain; a flange; a gate impedance matching network connected between the gate lead frame and the gate; and a drain impedance matching network connected between the drain lead frame and the drain, the drain impedance matching network including a drain lead frame bond wire between the drain lead frame and the drain, and a first conducting element electrically connected at both a first end and a second end to the flange and arranged to provide a current path along which a return current can flow in use to lower an inductance associated with the drain lead frame bond wire.

The arrangement of the first conducting element may reduce the inductance associated with the drain lead frame bond wire, compared to the inductance it would have in the absence of the first conducting element. A lower inductance associated with the drain lead frame bond wire may help to reduce the Q of the RF power transistor's output impedance, which in turn may make it easier to design an impedance matching network for other components to be attached to the RF power transistor and may also improve its broad band performance. Further, providing a conducting path for the return current may help to reduce losses otherwise caused by the return current passing over any lossy parts or components on the flange, thereby improving efficiency.

The invention may be used with a variety of different power transistors. For example, the power transistor may be an LDMOS power transistor or a GaN power transistor.

The RF power transistor may handle electrical signal powers of at least 5Watts or electrical signal powers in the range of from 5Watts to 1400Watts.

The RF power transistor may handle electrical signal frequencies of at least 10MHz or electrical signal frequencies in the range of from 10MHz to 6000MHz.

The first conducting element may include a first portion and the drain lead frame bond wire may include a first portion and the first portion of the first conducting element may be arranged adjacent and/or parallel to the first portion of the drain lead frame bond wire. Arranging the first conducting element adjacent the drain lead frame bond wire may help to reduce the area of the loop formed by the drain lead frame bond wire and the first conducting element thereby improving reduction of the inductance associated with the drain lead frame bond wire. Arranging the first conducting element parallel to the drain lead frame bond wire further may help to minimise the area of the loop formed by the drain lead frame bond wire and the first conducting element.

The first portion of the first conducting element may be at least one half, at least two thirds or at least three quarters of the total length of the first conducting element. The greater the amount of first conducting element that is adjacent and/or parallel to the drain lead bond wire, the greater the reduction in its associated inductance.

An area of a loop formed by the drain lead frame bond wire and first conducting element may be less than a quarter, or less than a third, or less than one half, or less than two thirds or less than three quarters of an area of a loop formed by the drain lead frame bond wire and a region of the flange between the die and the drain lead frame. The greater the reduction in the area of the loop that would be formed by the drain lead frame bond wire in the absence of the first conducting element, the greater the reduction in the associated inductance.

The first end and/or the second end of the first conducting element may be electrically connected directly to the flange.

The first conducting element may be electrically connected to the flange by the die. The power transistor may include a source metal shield and the first end of the first conducting element may be connected to the source metal shield. This can further improve the efficiency by the source metal shield providing a conducting path for the return current to the first conducting element.

The drain impedance matching network may include a first capacitor and a drain bond wire connected between the drain and the first capacitor. The first conducting element may be further arranged with a portion of the first conducting element overlapping with a portion of the drain bond wire and providing a current path along which a return current may flow in use to lower a mutual inductance associated with the drain bond wire and drain lead frame bond wire. Reducing the mutual inductance of the drain impedance matching network may further help to increase the real part of the output impedance seen after the drain impedance matching network. Increasing the real part of the output impedance may improve the power gain of the RF power transistor.

The first conducting element may be arranged above the drain lead frame bond wire or between the drain lead frame bond wire and the flange. However, it may be easier to manufacture devices with the conducting element between the drain lead frame bond wire and the flange

The semiconductor device may include a plurality of drain lead frame bond wires and a plurality of first conducting elements. Each first conducting element may be positioned between a respective one of the plurality of drain lead frame bond wires and the flange.

The first end and/or the second end of the or each first conducting element may be electrically connected directly to the flange.

The semiconductor device may include a drain end grounded bond bar which is electrically connected to the flange and each first conducting element may be connected to the drain end grounded bond bar. The gate impedance matching network may include a second capacitor, a gate lead frame bond wire connected between the gate lead frame and the second capacitor, and a second conducting element electrically connected at a first end and a second end to the flange and arranged to provide a current path along which a return current may flow in use to lower an inductance associated with the gate lead frame bond wire.

The second conducting element may be arranged to reduce the inductance associated with the gate lead frame bond wire, compared to the inductance it would have in the absence of the second conducting element. A lower inductance associated with the gate lead frame bond wire may help to reduce the Q of the RF power transistor's input impedance making it easier to design an impedance matching network for other components to be attached to the RF power transistor and may also further improve its broad band performance.

The second conducting element may include a first portion and the gate lead frame bond wire may include a first portion and the first portion of the second conducting element may be arranged adjacent and/or parallel to the first portion of the gate lead frame bond wire. Arranging the second conducting element adjacent the gate lead frame bond wire helps to reduce the area of the loop formed by the gate lead frame bond wire and the second conducting element thereby improving reduction of the inductance associated with the gate lead frame bond wire. Arranging the second conducting element parallel to the gate lead frame bond wire may further help to minimise the area of the loop formed by the gate lead frame bond wire and the first conducting element.

The first portion of the second conducting element may be at least one half, at least two thirds or at least three quarters of the total length of the second conducting element. The greater the amount of second conducting element that is adjacent and/or parallel to the gate lead frame bond wire, the greater the reduction in its associated inductance.

An area of a loop formed by the gate lead frame bond wire and second conducting element may be less than a quarter, or less than a third, or less than one half, or less than two thirds or less than three quarters of an area of a loop formed by the gate lead frame bond wire and a region between the second capacitor and the gate lead frame. The greater the reduction in the area of the loop that would be formed by the gate lead frame bond wire in the absence of the second conducting element, the greater the reduction in the associated inductance.

The first end of the second conducting element may be electrically connected to the flange by the second capacitor. The second capacitor may include a grounded connection on an upper surface to which the first end is connected. The second capacitor may include a lower plate connected to the flange and the first end of the second conducting element may be connected to the lower plate of the second capacitor.

The second conducting element may be arranged above the gate lead frame bond wire or between the gate lead frame bond wire and the flange. However, it may be easier to manufacture devices with the conducting element between the drain lead frame bond wire and the flange.

The semiconductor device may include a plurality of gate lead frame bond wires and a plurality of second conducting elements. Each second conducting element may be positioned between a respective one of the plurality of gate lead frame bond wires and the flange.

The semiconductor device may include a gate end grounded bond bar which is electrically connected to the flange and each second conducting element may be connected to the gate end grounded bond bar.

The first end and/or the second end of the or each second conducting element may be electrically connected directly to the flange.

The RF power transistor may operate at frequencies in the range of between 400MHz and 4GHz or between 900MHz and 3GHz.

The RF power transistor may operate at frequencies up to 5GHz. LDMOS technology can work up to 5GHz or sometime higher while still delivering reasonable gain.

The RF power transistor may operate at a frequencies over 400MHz.

The RF power transistor may operate over the frequency range of substantially 1800MHz to 2200MHz or substantially 2300MHz to 2700MHz These ranges of frequencies are particularly suitable for telecommunications applications.

A further aspect of the invention provides a semiconductor device comprising an RF power transistor in a semiconductor package, comprising: a gate lead frame; a drain lead frame; a die including an RF power transistor having a gate and a drain; a flange; a gate impedance matching network connected between the gate lead frame and the gate; and a gate impedance matching network connected between the gate lead frame and the gate, the gate impedance matching network including a gate lead frame bond wire between the gate lead frame and the gate, and a second conducting element electrically connected at a first end and a second end to the flange and arranged to provide a current path along which a return current can flow in use to lower an inductance associated with the gate lead frame bond wire.

Optional features of the first aspect of the invention may also be optional features of this further aspect of the invention.

A second aspect of the invention provides an RF power amplifier including the semiconductor device of the first aspect of the invention.

The RF power amplifier may amplify electrical signals in the frequency range of 400MHz to 4GHz.

A third aspect of the invention provides a telecommunications base station including the RF power amplifier of the second aspect of the invention.

Embodiments of the invention will now be described in detail, by way of example only, and with reference to the accompanying drawings, in which:
Figure 1 shows a perspective view of part of a first embodiment of an RF power transistor package according to the invention;
Figure 2 shows a cross sectional view through Figure 1;
Figure 3 shows an equivalent circuit diagram for Figure 2;
Figure 4 shows a graphical plot of the real and imaginary parts of the impedance presented on the drain lead frame as a function of frequency for an RF power transistor not using the invention;
Figure 5 shows a graphical plot of the real and imaginary parts of the impedance presented on the drain lead frame as a function of frequency for an RF power transistor using the invention; and
Figure 6 shows a cross sectional view through a part of a second embodiment of an RF power transistor package according to the invention;
Figure 7 shows an equivalent circuit diagram for Figure 6;
Figure 8 shows a plan view of a part of an RF power transistor package according to a third embodiment of the invention; and
Figure 9 shows a schematic block diagram of a telecommunications base station according to an aspect of the invention, including an RF power amplifier according to an aspect of the invention and including an RF power transistor according to the invention.

Similar items in the different Figures share common reference signs unless indicated otherwise.

In the following, it will be appreciated that when elements are described as being connected or electrically connected, that connection may be direct or indirect via one or more intervening parts, components or elements, unless the context requires otherwise. Further, where a part is connected between first and second parts the part may simply be at a location between the first and second and not necessarily extending from the first to the second part, unless the context requires otherwise.

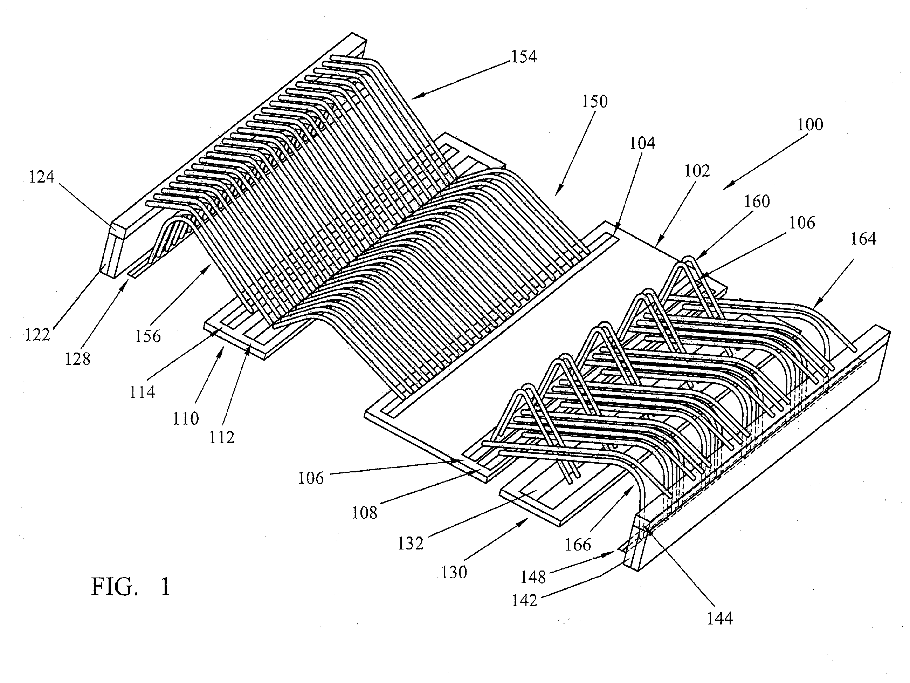

With reference to Figure 1, there is shown a perspective view of an RF power transistor assembly 100 part of a semiconductor device according to a first embodiment of the invention. The RF power transistor assembly includes a die 102 which includes a semiconductor transistor. In various embodiments, the die can include one transistor, two transistors or four transistors, although a greater or lesser number of transistors can also be provided. The transistor can be an LDMOS transistor although other specific transistors can be used including GaN transistors. The construction and operation of LDMOS and GaN transistors is known generally to a person of ordinary skill in the art and is not described further herein. The die 102 includes a gate bond bar 104 and a drain bond bar 106 and a further bond bar 108.

The assembly 100 includes a first capacitor 130 and a drain lead frame 144. First capacitor 130 includes a first capacitor bond bar 132. The drain lead frame 144 is supported by an insulating body 142.

The assembly 100 also includes a second capacitor 110 and a gate lead frame 124. Second capacitor 110 includes a second capacitor bond bar 112 and a further second capacitor bond bar 114. The further second capacitor bond bar 112 is grounded and in particular is connected to a lower plate of the second capacitor 110 which is connected to ground by an electrical connection to a flange (not shown in Figure 1) of the RF power transistor assembly 100. The gate lead frame 124 is suported by an insulating body 122.

The gate bond bar 104 of the die 102 is electrically connected to the second capacitor bond bar 112 by a plurality of gate bond wires 150. The second capacitor bond bar 112 is electrically connected to the gate lead frame 124 by a plurality of gate lead frame bond wires 154. The second capacitor grounded bond bar 114 is electrically connected to a grounded bond bar 128 located toward a gate end of the assembly by a plurality of gate or second conducting elements 156 of the same number as the number of gate lead frame bond wires 154. The plurality of second electrically conducting elements 156 can each be in the form of a bond wire. The gate side grounded bond bar 128 is located adjacent the gate lead frame 124 and is electrically connected to the flange of the RF power transistor assembly 100 which is grounded in use.

The drain bond bar 106 of the die 102 is electrically connected to the first capacitor bond bar 132 by a plurality of drain bond wires such as drain bond wire 160. The first drain bond bar 106 is also electrically connected to the drain lead frame 144 by a plurality of drain lead frame bond wires such as drain lead frame bond wire 164. The further bond bar 108 is electrically connected to a grounded bond bar 148 located toward a drain end of the assembly by a plurality of drain or first conducting elements, such conducting element 166. Typically, the number of second conducting elements provided can be the same as the number of drain lead frame bond wires 164 (such that one conducting element can be provided for each respective drain lead frame bond wire). In other embodiments, the number of second conducting elements can be greater than the number of drain lead frame bond wires (e.g. two per drain lead frame bond wire) or fewer (e.g. one per two drain lead frame bond wires). The plurality of first electrically conducting elements can each be provided in the form of a bond wire. The drain side grounded bond bar 148 can be located adjacent the drain lead frame 144 and grounded by being electrically connected to the flange of the RF power transistor assembly 100.

The various different bond wires of the assembly 100 can comprise a conductive material such as a metal or alloy. In one example, the bond wires can comprise aluminium. The attachment and fabrication of bond wires and bond bars in general is known to a person of ordinary skill in the art. However, the specific arrangement of bond wires shown in Figure 1, and in particular wires 156 and 166, is not known in the art.

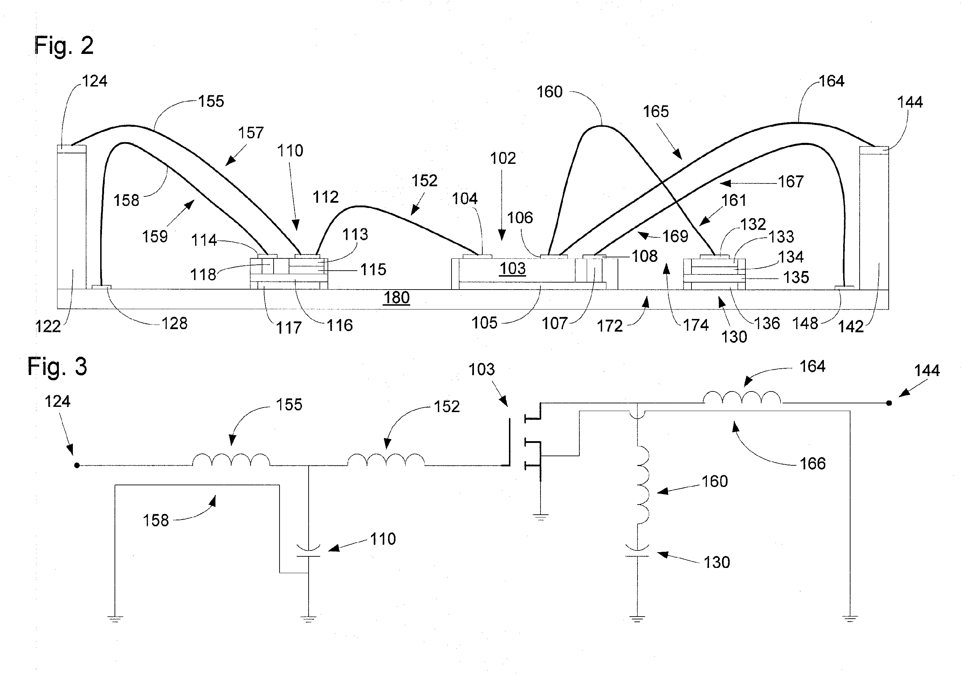

Figure 2 shows a cross sectional block diagram through the assembly 100 shown in Figure 1 along a drain-gate axis of the assembly 100. Figure 2 shows the assembly 100 of Figure 1 mounted on a flange 180 made of, for example, aluminium. Flange 180 is electrically connected to the source of the transistor on the die 102 and in use the flange 180 is typically electrically connected to ground. Figure 2 shows a specific one 155 of the plurality of gate lead frame bond wires 154 and a specific one 158 of the plurality of second conducting elements 156. Figure 2 also shows a specific one 164 of the plurality of drain lead frame bond wires, a specific one 160 of the plurality of drain bond wires and a specific one 166 of the first conducting elements.

The first capacitor 130 and the second capacitor 110 can each be a metal-insulator-metal capacitor (MIMCAP) as are generally known in the art. The first capacitor includes first capacitor bond bar 132 on a top plate 133, followed by an insulator layer 134, a bottom plate 135 and a plurality of vias 136 by which the bottom plate 135 is connected to the flange 180 and grounded. The second capacitor 110 is constructed similarly and includes the second capacitor bone bar 112 on a top plate 113, followed by an insulator layer 115, a bottom plate 116 and a plurality of vias 117 by which the bottom plate 116 is connected to the flange 180 and grounded. The second capacitor also includes vias 118 which connect the further grounded bond bar 114 directly to the bottom plate 116 and hence to ground.

The construction of the transistor die 102 is also illustrated schematically in Figure 2. The transistor die 102 includes the LDMOS transistor itself 103 to which the gate bond bar 104 and drain bond bar 106 are connected. A metal layer 105 below the transistor is a source metal shield and is connected to the further bond bar 108 by a plurality of vias 107.

As shown in Figure 1 and best illustrated in Figure 2, a significant amount of a first portion 159 of the gate conducting element 158 is located adjacent to and arranged parallel with a significant amount of a first portion 157 of the gate lead frame bond wire 155. As illustrated in Figure 2, over half the length of the gate conducting element 158 is parallel with over half the length of the gate lead frame bond wire 155. The gate lead bond wire 155 and gate conducting element 158 from a loop around which current can flow. This loop encloses a smaller area than the area defined by the gate lead frame bond wire 155 alone and which helps to reduce the inductance associated with gate lead frame bond wire 155 as described in greater detail below.

Similarly a significant amount of a first portion 167 of the drain conducting element 166 is located adjacent to and arranged parallel with a significant amount of a first portion 165 of the drain lead frame bond wire 164. Again, over half the length of the drain conducting element 166 is parallel with over half the length of the drain lead bond wire 164. The drain lead frame bond wire 164 and drain conducting element 166 form a loop around which current can flow. This loop encloses a smaller area than the area defined by the drain lead frame bond wire 164 alone and which helps to reduce the inductance associated with drain lead frame bond wire 164 as described in greater detail below.

It will be appreciated that the exact length and portion of the drain conducting element or gate conducting element which is adjacent the drain lead frame bond wire and gate lead frame bond wire respectively will depend on the specific geometry and arrangement of the assembly and may vary. However, the objective is to reduce the size of the loop that otherwise would be formed by the respective lead frame bond wires and the flange alone.

Also, a drain end portion 169 of the drain conducting element overlaps in space a second capacitor end portion 161 of the drain bond wire 160. Hence, a region 172 of the substrate local to the die 102 and second capacitor 130 and the first end portion 169 and the region 172 of the substrate and second capacitor end portion 161 define an overlapping area 174 in space. As the currents in the drain conducting element 166 and drain bond wire 160 flow in opposite directions this can help reduce the mutual inductance between the drain lead frame bond wire and drain bond wire.

Figure 3 shows an equivalent circuit diagram 190 for the arrangement of components shown in Figure 2 and including the transistors 103 of die 102. At the RF frequencies at which the RF power transistor is designed to operate, typically 0.4GHz to 3.8GHz, the bond wires act as inductors and have an associated inductance.

As illustrated in Figure 3, gate lead frame bond wire 155 acts as an inductance which is connected in series with gate bond wire 152 which also acts as an inductance and which is connected to the gate electrode of transistor 103. The transistor 102 has an intrinsic input capacitance at its gate. The gate bond wire 152 is connected to ground through second capacitor 110. The inductance of gate bond wire 152 and the second capacitor form elements of an in-package input impedance matching network and provide a resonant circuit in series with the input capacitance of the transistor 103.

The drain lead frame bond wire 164 acts as an inductance which is connected to the drain of the transistor. The drain bond wire 160 also acts as an inductance and is connected to ground via the first capacitor 130. The transistor 103 has an intrinsic output capacitance. The output capacitance of the transistor forms a parallel resonance with the inductance of the drain bond wire 160 to ground via first capacitor 130 and provides an in-package output impedance matching network, sometime referred to as an INSHIN or shunt inductance network. At resonance, the output capacitance of the transistor 103 is reduced or eliminated by the parallel inductance 160, resulting in an increased output impedance of the transistor. This increased output impedance makes the design of external impedance matching network easier.

However, the in-package input impedance matching network and output impedance matching network can have other effects on the overall electrical behaviour of the RF power transistor.

For an RF power transistor, the input resonance frequency is typically set a few hundred MHz higher than the maximum frequency of operation. A consequence of this is that the input impedance becomes inductive and the inductance of the gate lead frame bond wire 155 makes the input impedance even more inductive. This makes the Q of the input impedance quite high. The high Q of the input impedance makes the design of a broad-band impedance matching network external to the package very difficult.

On the output side, the internal load impedance is lowered by the output capacitance of the transistor, but the shunt inductance 160 transforms the load impedance back to several Ohms or even lower. The inductance of the drain lead frame bond wire 164 makes the output impedance more inductive, or in other words, increases the Q of the load impedance presented by the RF power transistor. A high Q load impedance also makes it difficult to design a broad-band impedance matching network external to the package.

Also, the overlap between the drain bond wire 160 and the drain lead frame bond wire 164 gives rise to a magnetic coupling in the form of a mutual inductance. This mutual inductance presents an 'extra' inductance in series with the drain of the transistor 103 and before the inductance 160. This mutual inductance further transforms the load impedance of the transistor 103 along the impedance circle back to the real axis of the Smith chart, before the inductance 160 become effective.

Further, gain and efficiency are also important electrical characteristics of a typical RF power transistor. Hence, it can be important to try to reduce any losses in the in-package input or output matching networks. In the absence of gate conducting element 158 and drain conducting element 166, during operation the return current will flow between the gate lead frame 124 and second capacitor 110 and also between the drain lead frame 144 and transistor die 102 over the first capacitor 130 and hence give rise to loss in the output impedance matching networks. As a consequence, the gain and efficiency of the RF power transistor are reduced. It is believed that the majority of the loss occurs owing to the return current flow over the first capacitor 130.

As illustrated in Figures 1 to 3, a conducting element in the form of a bond wire, e.g., 158, 166, is included for each respective gate lead frame bond wire, e.g. 155, and each respective drain lead frame bond wire, e.g. 164. Generally, the conducting elements 158, 166 are located underneath the lead frame bond wires, i.e. between the lead frame bond wires and the flange 180, and in parallel with the lead frame bond wires with a small distance between them. Sufficient spacing is used to avoid short circuits, but while reducing the area of the loop they form as much as practicable. One end of each gate conducting element 158 is bonded by gate end grounded bond bar 128 to the flange 180, which is RF grounded and the other end is bonded to the further second capacitor bond bar 114 on the cap of the second capacitor 110 and which is also connected to ground as described above.

Similarly, the drain conducting element 166 is parallel to drain lead frame bond wire 164 with a small distance between them. Sufficient spacing is used to avoid short circuits, but while reducing the area of the loop they form as much as practicable. One end of the drain conducting element is bonded to the drain end grounded bond bar 148 to the flange 180, which is RF grounded and the other end is bonded to the further bond bar 108 on the die 102 and which is also ultimately connected to ground. In particular, the further bond bar 108 is connected by vias 107 to the transistor source metal shielding 105 as well.

With the drain conducting element, 166, the return current of the drain lead frame bond wire 164 will flow on the drain conducting element 166, instead of the flange and over the first capacitor 130. The drain lead frame bond wire 164 and drain conducting element now forms a loop which is much smaller than the loop formed by the drain lead frame bond wire 164 and the portion of the flange between the die 102 and drain lead frame 144 and hence the effective inductance of the drain lead frame bond wire 164 is significantly reduced.

Further, the mutual coupling between the drain bond wire 160 and the drain lead frame bond wire 164 is positive because of the direction of current flow is the same in both of them. However, the mutual coupling between the drain bond wire 160 and drain conducting element 166 is negative because the current flow is in opposite directions in them. The positive and negative mutual couplings can compensate for each other and hence the net effective mutual coupling on the drain bond wire 160 can be significantly reduced. The amount of mutual inductance between the drain bond wire 160 and drain conducting element 166 is proportional to the size of the overlapping area 174 and hence can be as large as practicable to reduce the net effective mutual coupling.

As noted above, the further bond bar 108 is connected to the transistor source metal shielding as well. Therefore, the source current from the intrinsic transistor 103 firstly flows on the source metal shielding, and then flows onto the drain conducting element 166. Since the drain conducting element 166 is made of a good conductor the parasitic resistance is low. This also helps to reduce the loss on the return current path between the transistor die 102 and the drain lead frame 144.

With regard to the gate conducting element 158, the return current of the gate lead frame bond wire 155 can now flow on the gate conducting element 158 instead of the flange. The gate lead frame bond wire 155 and the gate conducting element now forms a loop which is much smaller than that formed by gate lead frame bond wire 155 and the portion of the flange between the first capacitor 110 and the gate lead frame 124 and hence the effective inductance of the gate lead frame bond wire 155 can be significantly reduced.

In another embodiment either or both of the drain conducting elements and the gate conducting elements can be provided above the drain lead frame bond wires and gate lead frame bond wires respectively, rather than below them. However, this arrangement can be more difficult to manufacture.

A consequence of using the drain conducting element 166 is that the Q of the output impedance of the RF power amplifier can be significantly lowered which makes broad band impedance matching easier. Similarly, the gate conducting element 158 can make the Q of the input impedance of the RF power amplifier significantly lower which can make broad band impedance matching easier. Further, the drain conducting element 166 can increase the real part of output impedance of the RF power amplifier which can also make broad band impedance matching easier.

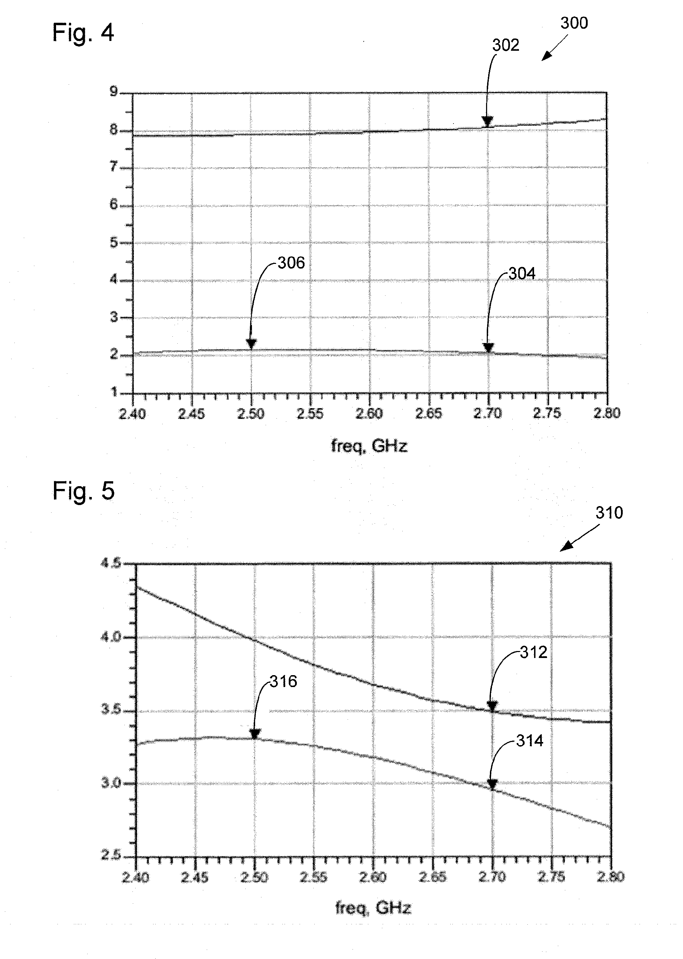

This is illustrated in Figures 4 and 5. Figure 4 shows a graphical representation 300 of a plot 302 of a simulation of the imaginary part of the output impedance on the drain lead frame of an RF power transistor without the gate conducting element 158 or the drain conducting element 166, over the frequency range of 2.4GHz to 2.8GHz. Figure 4 also shows a plot of the real part 304 of the output impedance for the same simulation. As can be seen, the real part of the impedance at about 2.5GHz 306 is around 2 Ohms and the Q of the output impedance at about 2.5GHz is about 4.

Figure 5 shows a graphical representation 310 of a plot 312 of a simulation of the imaginary part of the output impedance on the drain lead frame of an RF power transistor including the gate conducting element 158 and drain conducting element 166, over the frequency range of 2.4GHz to 2.8GHz. Figure 5 also shows a plot of the real part 314 of the output impedance for the same simulation. As can be seen, the real part of the impedance at about 2.5GHz 316 is around 3.3 Ohms and the Q of the output impedance at about 2.5GHz is about 1.2.

Further, as the drain conducting element provides a more conductive path for the return current, loss in the in-package impedance matching network can be reduced thereby increasing the efficiency of the RF power transistor.

Furthermore, the reduced Q of the RF power transistor can improve the broad band performance of the RF power transistor as a lower Q corresponds to an increased range of frequency over which the RF power transistor can operate.

Hence, a number of benefits can arise from the use of the gate conducting element or the drain conducting element individually or both together in the in-package impedance matching networks of an RF power transistor.

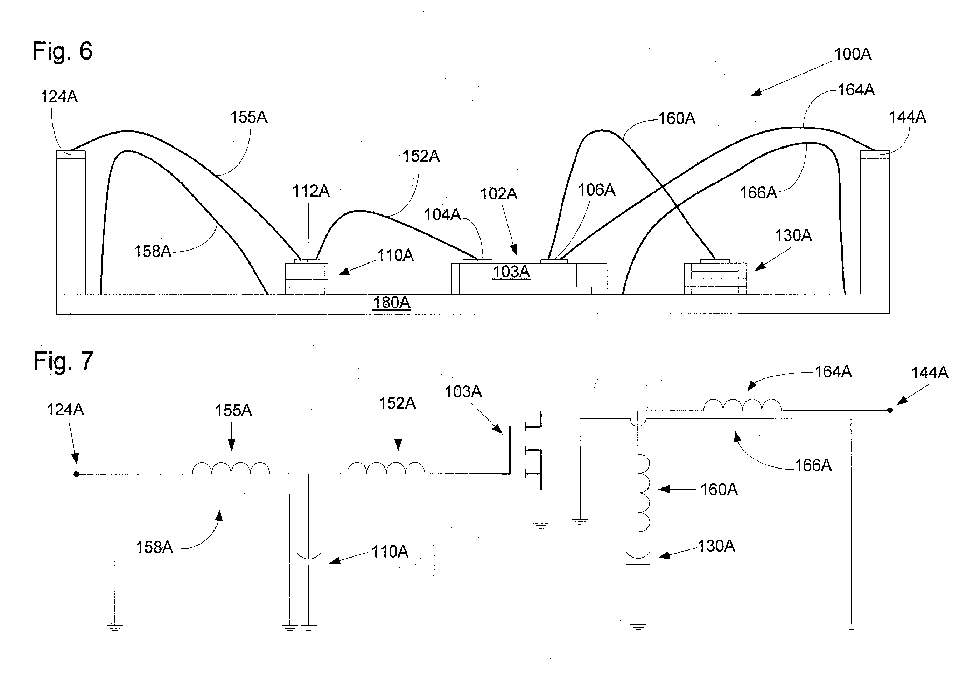

Figures 6 and 7 show a second embodiment of the invention. The second embodiment is similar to the first embodiment, but the ends of the gate conducting elements and the ends of the drain conducting elements are each connected directly to the flange rather than via any intervening components or parts. Similar parts in Figures 6 and 7 generally share the same reference numerals as for the first embodiment but suffixed by A.

Hence, in RF power transistor assembly 100A the gate conducting element 158A is connected directly to the flange 180A at each of its ends. Hence, second transistor 110A includes only bond bar 112A and does not include a grounded bond bar. Die 102A includes gate bond bar 104A and drain bond bar 106A but does not include a grounded bond bar. Drain conducting element 166A is connected directly to flange 180A at each of its ends.

Hence, as further illustrated by the equivalent circuit diagram of Figure 7, the ends of the gate conducting element 158A are connected directly to ground and similarly the ends of the drain conducting element are connected directly to ground. In embodiments in which the flange material is not suitable for wire bonding, bond bars can be used as described for the first embodiment.

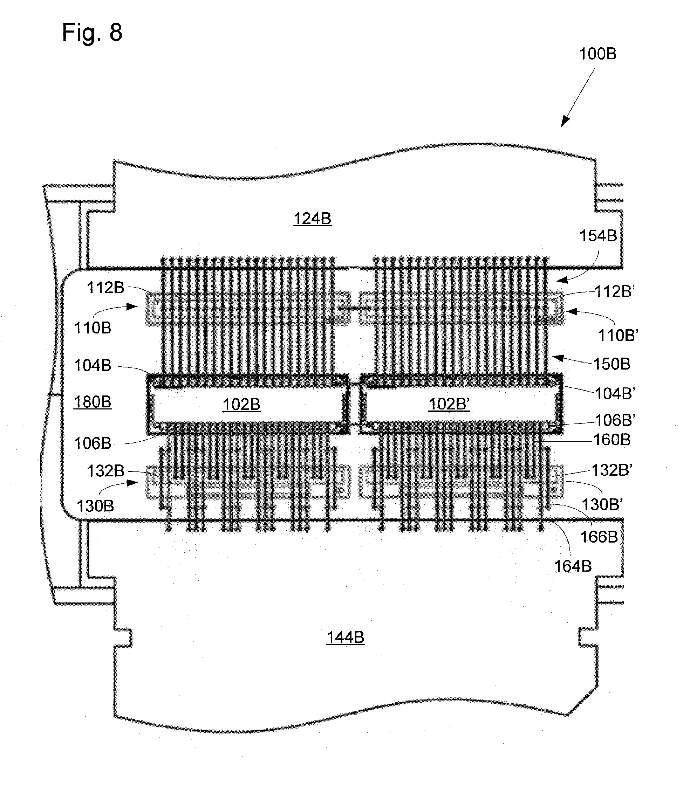

Figure 8 shows a third embodiment of the invention and in particular a plan view of an RF power transistor assembly 100B. Similar parts in Figure 8 generally share the same reference numerals as for the first and second embodiments but suffixed by B.

The third embodiment is similar to the first and second embodiments, but includes two dies 102B and 102B', two first capacitors 130B, 130B' electrically connected, two second capacitors 110B, 110B'electrically connected, a gate lead frame 124B and a drain lead frame 144B. A plurality of gate lead frame bond wires 154B are connected between the gate lead frame 124B and the second capacitor bond bars 112B, 112B' and a plurality of gate bond wires 150B are connected between the second capacitor bond bars 112B, 112B' and the electrically connected gates 104B' of the dies. In this third embodiment, no gate conducting elements are provided as part of the input impedance matching network.

A plurality of drain bond wires, e.g. drain bond wire 160B, are connected between the electrically connected drains 106B, 106B' of the dies and the first capacitor bond bars 132B, 132B'. A plurality of drain lead frame bond wires, e.g. drain lead frame bond wire 164B, are connected between the drains 106B, 106B' and the drain lead frame 144B. A plurality of drain conducting elements, e.g. drain conducting element 166B, are provided connected directly to the flange 180B, spanning the first transistors 130B, 130B', and positioned generally between the drain lead frame bond wires and the flange 180. In this third embodiment, drain gate conducting elements are provided as part of the output impedance matching network as the improvements in performance of the RF power transistor are greater for the output impedance matching network. However, in other embodiments, conducting elements can be provided in the input impedance matching network only or in both the input and output impedance matching network.

An RF power transistor according to embodiments of the invention is particularly suitable for use in an RF power amplifier. One area in which RF power amplifiers can be used is in telecommunications base stations owing to the range of RF frequency electrical signals used and the high electrical signal powers that are needed in order to drive the antenna.

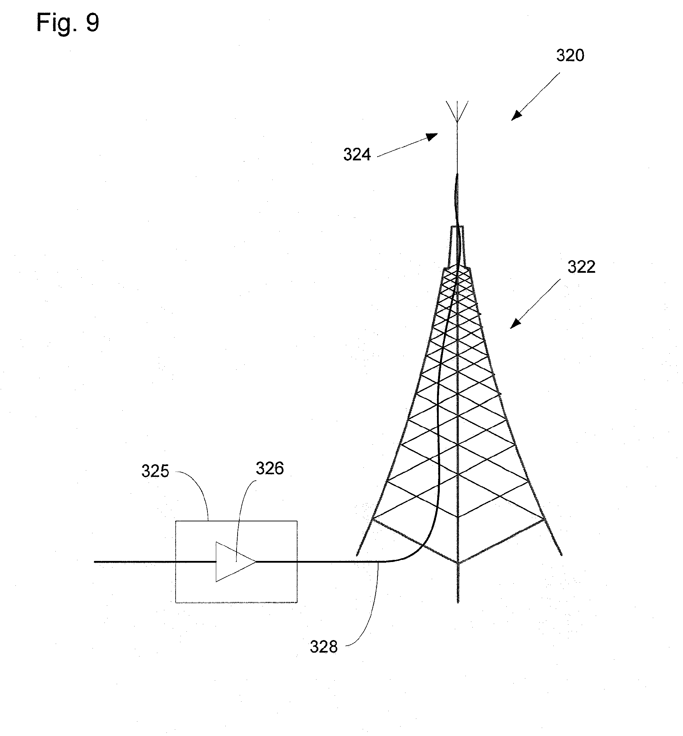

For example, Figure 9 shows a schematic block diagram of a telecommunications base station 320 including a tower or pylon 322 supporting an antenna 324, which may include transmitting and receiving antennae. The base station 320 is connected to the rest of the telecommunications infrastructure and will typically include a number of electronics elements 325, such as one or more amplifiers 326, radio transceivers, RF combiners, control elements, communications elements and a backup power supply. The transmitter output side of the radio transceivers is supplied to a high power RF amplifier 326 with a typical power of 10 to 50 Watts which amplifies the signals to produce a higher power RF signal sufficient to drive the transmitter antenna. The amplified RF signal is passed to the transmitter antenna 304 by a cable 328. The RF power amplifier 326 can include one or a plurality of, for example two, RF power transistors according to the invention.

Although the above has generally described the present invention in relation to a specific LDMOS transistor assembly, the present invention has a broader range of applicability. For example, the invention can also be applied to GaN RF power transistors. One of ordinary skill in the art would recognize other variants, modifications and alternatives in light of the foregoing discussion.

## Claims

1. A semiconductor device comprising an RF power transistor in a semiconductor package, comprising:
a gate lead frame;
a drain lead frame;
a die including an RF power transistor having a gate and a drain;
a flange;
a gate impedance matching network connected between the gate lead frame and the gate; and
a drain impedance matching network connected between the drain lead frame and the drain, the drain impedance matching network including a drain lead frame bond wire between the drain lead frame and the drain, and a first conducting element electrically connected at both a first end and a second end to the flange and arranged to provide a current path along which a return current can flow in use to lower an inductance associated with the drain lead frame bond wire.

2. The semiconductor device of claim 1, wherein the first conducting element includes a first portion and the drain lead frame bond wire includes a first portion and the first portion of the first conducting element is arranged adjacent and parallel to the first portion of the drain lead frame bond wire.

3. The semiconductor device of any of claim 1 or 2, wherein the first end of the first conducting element is electrically connected to the flange through the die.

4. The semiconductor device of claim 3, wherein the RF power transistor is an LDMOS transistor which includes a source metal shield and wherein the first end of the first conducting element is electrically connected to the source metal shield.

5. The semiconductor device of any of claims 1 to 4, wherein the drain impedance matching network includes a first capacitor and a drain bond wire connected between the drain and the first capacitor and wherein the first conducting element is further arranged with a portion of the first conducting element overlapping with a portion of the drain bond wire and providing a current path along which a return current can flow in use to lower a mutual inductance associated with the drain bond wire and drain lead frame bond wire.

6. The semiconductor device of any of claims 1 to 5, wherein the first conducting element is arranged between the drain lead frame bond wire and the flange.

7. The semiconductor device of any of claims 1 to 6, and including a plurality of drain lead frame bond wires and a plurality of first conducting elements and wherein each first conducting element is positioned between a respective one of the plurality of drain lead frame bond wires and the flange.

8. The semiconductor device of any of claims 1 to 7, wherein the gate impedance matching network includes a second capacitor, a gate lead frame bond wire connected between the gate lead and the second capacitor, and a second conducting element electrically connected at a first end and a second end to the flange to provide a current path along which a return current can flow in use to lower an inductance associated with the gate lead frame bond wire.

9. The semiconductor device of claim 8, wherein the second conducting element includes a first portion and the gate lead frame bond wire includes a first portion and the first portion of the second conducting element is arranged adjacent and parallel to the first portion of the gate lead frame bond wire.

10. The semiconductor device of any preceding claim, wherein the first conducting element and drain lead frame bond wire form a loop having an area less than an area of a loop formed by the drain lead frame bond wire and the flange and/or wherein the second conducting element and the gate lead frame bond wire from a loop having an area less than an area of a loop formed by the gate lead frame bond wire and the flange.

11. The semiconductor device of any of claims 8 to 10, wherein the first end of the second conducting element is electrically connected to the flange through the second capacitor.

12. The semiconductor device of claim 11, wherein the second capacitor includes a lower plate electrically connected to the flange and wherein the first end of the second conducting element is electrically connected to the lower plate of the second capacitor.

13. The semiconductor device of any of claims 8 to 12, and including a plurality of gate lead frame bond wires and a plurality of second conducting elements and wherein each second conducting element is positioned between a respective one of the plurality of gate lead frame bond wires and the flange.

14. An RF power amplifier including the semiconductor device of any preceding claim.

15. A telecommunications base station including the RF power amplifier of claim 14.
